# EUROPEAN PATENT APPLICATION

(11) **EP 2 017 893 A2**
(43) Date of publication of application: **21.01.2009**
(21) Application number: 08160497.7
(22) Date of filing: 16.07.2008
(51) Int. Cl.: H01L 31/052

(54) **A method and device for generating an electrical signal in response to light**

(30) Priority: 17.07.2007 US 826670
(71) Applicant: Lockheed Martin Corporation, Bethesda, Maryland 20817 (US)
(72) Inventor: Braunstein, Edit L., Gainsville, VA 20155 (US); Tener, Gene D., Oviedo, FL 32765 (US); Jones, Colin E., Santa Barbara, CA 93111 (US)
(74) Representative: Schwabe - Sandmair - Marx

(57) **Abstract**

A device and method are disclosed for detecting light. The device incudes a photodetector having at least one superlattice layer operative to generate an electrical signal in response to light incident thereon and one or more lenslets for directing light onto the photodetector.

## Description

### BACKGROUND INFORMATION

Detectors have been used to generate thermal images. A known infrared detector is described in U.S. Patent No. 7,001,794. In the '794 patent, an array of detector structures generate electric signals in response to the input light incident thereon and the signals are transmitted through an array of conductor bumps to external ReadOut Integrated Circuit (ROIC) unit cells. The outputs of the ROIC unit cells are processed to form an integrated representation of the signal from the detector.

### SUMMARY

According to an exemplary embodiment, a device for generating an electrical signal in response to light includes a photodetector having at least one superlattice layer operative to generate an electrical signal in response to light incident thereon; and one or more lenslets for directing light onto the photodetector.

According to another embodiment, a method of forming an image of an object includes: exposing a lenslet to light emitted from an object to cause the lenslet to direct the light onto a superlattice layer of a photodetector thereby causing the photodetector to generate an electrical signal in response to the light; and generating an image of the object from the electrical signal.

### BRIEF DESCRIPTION OF THE DRAWINGS

Exemplary preferred embodiments will be described in conjunction with the accompanying drawings, wherein like elements are represented by like reference numerals, and wherein:

FIG. 1 shows a schematic cross sectional diagram of a device according to an exemplary embodiment.

FIG. 2 shows a schematic cross sectional diagram of a device according to another exemplary embodiment.

### DETAILED DESCRIPTION

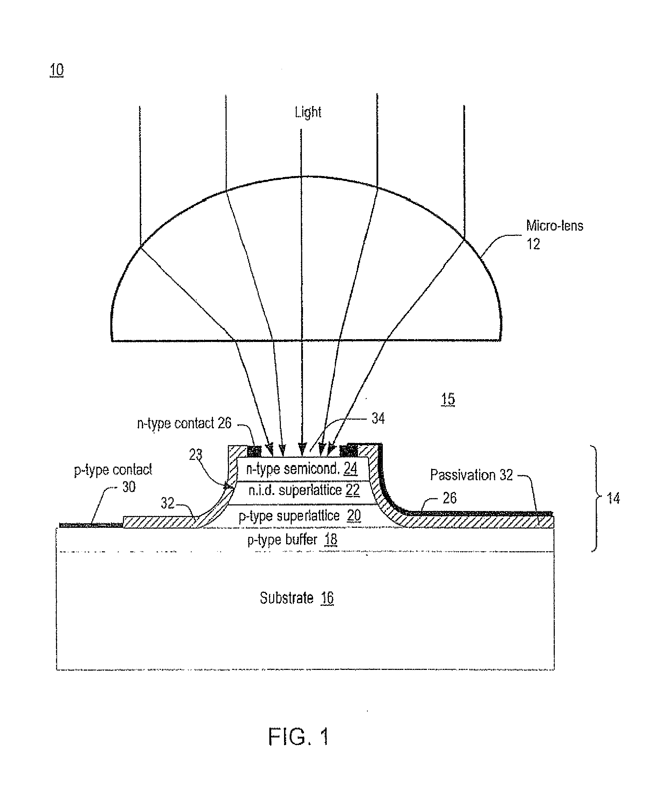

Referring now to FIG. 1, there is shown a schematic cross sectional diagram of a device 10 according to an exemplary embodiment. The operational wavelength range of the device 10 includes, but is not limited to, infrared (IR) range. Hereinafter, for the purpose of illustration, the device 10 is described as an IR detector, even though the device can operate in other wavelength ranges.

As depicted, the device 10 can be a front-side illuminated type device and include a photodetector 14 having at least one superlattice layer 20 operative to generate an electrical signal in response to light incident thereon and a lenslet 12 (e.g., micro-lens or other lens having a size selected as a function of the photodetector size wherein the photodetector is, for example, associated with a pixel in a light sensitive array). The letslet 12 is provided for directing (e.g., focusing or redirecting) light onto the photodetector.

The device 10 may also include a substrate 16, wherein the photodetector 14 is disposed on the substrate 16. The lenslet 12 and photodetector 14, when viewed from a given direction (e.g., when viewed from the top), may have either a circular or a rectangular shape, or any other suitable shape.

In an exemplary embodiment, the lenslet 12 is made of material that is substantially transparent to infrared light, such as quartz, cast plastic, Si, GaAs, polymers, chalcogenide glasses, Ge, Si, GaSb, and ZnS. The lenslet 12 can be fabricated separately from the photodetector 14. The surfaces of the lenslet 12 can be polished by various techniques to improve the light collection efficiency thereof. The lenslet 12 is shown to be a convex-plano lens, even though the surfaces of the lenslet may have other suitable curvatures.

In an exemplary embodiment, the photodetector 14 is in a spaced-apart relationship with the lenslet 12 by an air gap. In another exemplary embodiment, the space 15 is filled with a suitable material, e.g., plastic glue that is transparent to the incident light and provides mechanical strength to the device 10.

In an exemplary embodiment, the substrate 16 is made of, but not limited to, GaSb, GaAs, Si, or Ge, and may provide mechanical support for the photodetector 14. The photodetector 14, which can be a photodiode, can include a sequential stack of p-type buffer layer 18, p-type superlattice layer 20, non-intentionally-doped (NID) superlattice layer 22, an n-type contact layer 24; and an n-type contact 26. The three layers 20, 22, and 24, which are collectively referred to as a photosensitive pixel 23 hereinafter, can have a mesa shape and be formed on the p-type buffer layer 18. The photodetector 14 can also include a p-type contact 30 disposed on the p-type buffer layer 18 and a passivation layer 32 disposed over a portion of the p-type buffer layer 18 and the side of the mesa-shaped photosensitive pixel 23.

In an exemplary embodiment, the n-type contact 26 is formed of metal, such as Pt, Pd, Au, Ge, Ni, Ti, Al, and tungsten, and includes a hole or opening 34 to pass the light directed by the lenslet 12 therethrough. The electrical signal generated at the diode juncture between the p-type superlattice layer 20 and NID superlattice layer 22 in response to the directed light can be transmitted through the n-type contact 26 and p-type contact 30. The n-type contact 26 can extend over a portion of the passivation layer 32 such that the n-type contact 26 and p-type contact 30 can be respectively coupled to two opposite electrodes of a signal readout circuit (not shown in FIG. 1 for brevity). In an exemplary embodiment, the p-type contact 30 is formed of metal, such as Pt, Pd, Au, Ge, Ni, Ti, Al, and tungsten.

The passivation layer 32 can provide physical, chemical, and, in some cases, electrical protection for the photodetector 14. The material for the passivation layer 32 can include, but is not limited to, silicon dioxide, silicon nitride, wide band-gap semiconductors, AlGaSb, and AlGaInSb. The passivation layer 32 can be patterned or etched to have a hole or opening for the n-type contact 26.

The n-type contact layer 24 can be formed of material that is transparent to the light directed by the lenslet 12. In an exemplary embodiment, the n-type contact layer 24 is formed by doping an n-type dopant into conventional semiconductor material, such as InAs. In another exemplary embodiment, the n-type contact layer 24 is formed of an n-type superlattice layer, wherein the n-type superlattice layer includes alternating layers of InAs and InₓGa₁₋ₓSb for 0<x<1 and each layer is doped with an n-type dopant. The n-type contact layer 24 can be an electrically contacting and conducting layer through which the electrons can be transmitted from the n-type contact 26 to the NID superlattice layer 22.

The NID superlattice layer 22 can have a type II strained superlattice structure and form a diode juncture (or shortly, diode) with the p-type superlattice layer 20 to convert the directed light to an electrical current. The lateral dimension and thickness of the NID superlattice layer 22 can be set to absorb the directed light. In an exemplary embodiment, the NID superlattice layer 22 includes alternating layers of InAs and InₓGa₁₋ₓSb for 0<x<1, wherein the layers do not include any dopant impurity.

The p-type superlattice layer 20 can have a similar structure as the NID superlattice layer 22 but include a p-type dopant implanted therein. In an exemplary embodiment, the p-type superlattice layer 20 includes alternating layers of InAs and InₓGa₁₋ₓSb for 0<x<1 while each layer is doped with a p-type dopant, such as beryllium. Beneath the p-type superlattice layer 20 there can be a p-type buffer layer 18 which can provide an electrical contact between the p-type contact 30 and the p-type superlattice layer 20. The p-type buffer layer 18 can be formed of a semiconductor, such as GaSb, doped with a p-type dopant. In an exemplary embodiment, the p-type buffer layer 18 is formed by doping the top portion of the substrate 16 with a p-type dopant.

In an exemplary embodiment, the alternating layers of the superlattice layers 20, 22 are formed by epitaxially growing one layer on top of the other. By varying the thickness of the alternating layers, the energy bandgap and band structure of the superlattice (SL) layers 20, 22 can be changed and thereby the intended band gap for each application of the device 10 can be obtained. For instance, each of the alternating layers has a thickness of 30 - 40 Angstroms and each SL layer has a thickness of 1.5 - 4.5 µm.

Exemplary SL layers 20, 22 can posses a higher electron effective mass with a large separation between the heavy- and light-hole bands, which can suppress Auger recombination. Due to the suppression, the carrier lifetime can be an order of magnitude longer than the bulk material and the dark current can be reduced. Also, the suppression can allow the device 10 to operate at high temperatures, Each of the SL layers 20, 22 can have a bandgap shift to lower energy by, for example, ∼0.2 MeV/°K as temperature increases above 80 °K and the shift decreases even slower rate below 80 °K. Also, each of the SL layers 20, 22 can have an IR absorption coefficient comparable to HgₓCd₁₋ₓTe layer and has a quantum efficiency of 30 % or higher.

As the working temperature of known infrared detectors approaches the room temperature, the dark current level can increase exponentially with temperature, such that some known infrared detectors have cooling systems. Cooling can be provided by the evaporation of liquid gases, such as nitrogen. However, the storage, piping, and handing of coolants, such as liquid nitrogen, can be a difficult and expensive task.

In an exemplary embodiment, to reduce the dark current and thereby to operate the device 10 at high temperature, such as near room temperature, the active area of the photodetector 14 can be reduced. As depicted in FIG. 1, the lenslet 12 can direct the incoming light onto the active area of the photodetector 14 through the opening 34, allowing the active area to be reduced while the incoming light falls on the active area. (Hereinafter, the term active area refers to the projection area of the photosensitive pixel 23, i.e., the area of the pixel 23 seen from the top.) Therefore, by use of the lenslet 12, the dark current generated by the photodetector 14 can be reduced without compromising the sensitivity of the photodetector 14 and the quantum efficiency of the device 10.

The photodetector 14 can be fabricated by several techniques. In an exemplary embodiment, a stack of planar layers having the same layer sequence as the layers 18-26 can be formed on the substrate 16 using, for example, known metal organic chemical vapor deposition (MOCVD) or molecular beam epitaxy (MBE) technique. Other layers of the photodetector 14 can be formed by known deposition and etching techniques. Upon completion of fabricating the photodetector 14, the lenslet 12 can be aligned with and disposed in a spaced-apart relationship with the photodetector.

In an exemplary embodiment, the superlattice layer 20 can be an n-type superlattice layer, wherein the n-type superlattice layer includes alternating layers of InAs and InₓGa₁₋ₓSb for 0<x<1 and each layer is doped with an n-type dopant. In this embodiment, the layers 18 and 24 can be respectively n-type buffer layer and p-type contact layer (formed of p-type semiconductor or p-type superlattice). Also, the contacts 26 and 30 can be respectively p-type and n-type contacts, while these contacts can be formed of metal, such as Pt, Pd, Au, Ge, Ni, Ti, Al, and tungsten.

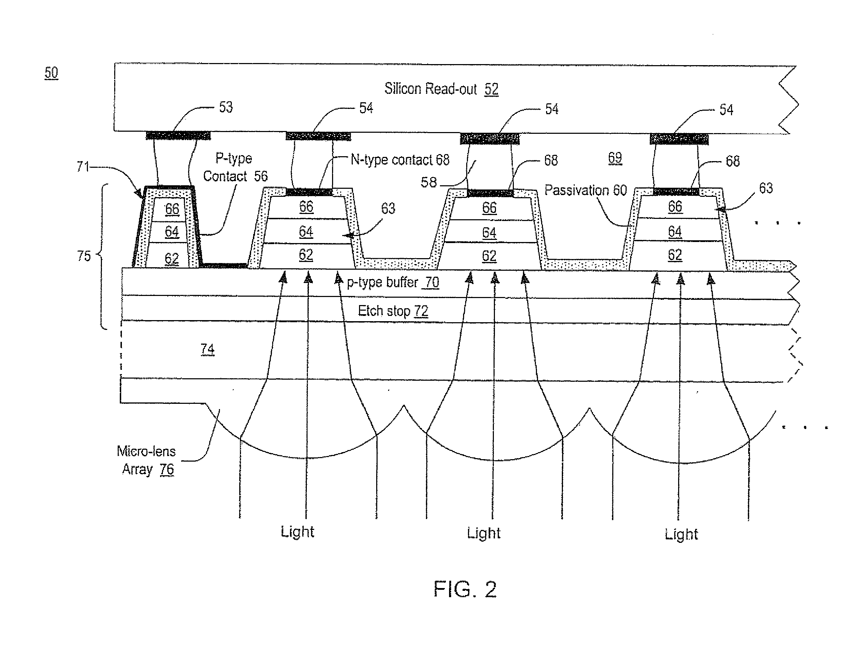

FIG. 2 shows a schematic cross sectional diagram of a device according to another exemplary embodiment. As depicted, the device 50 can be a back-side illuminated type device and referred to as a Focal Plane Array (FPA) detector. The device 50 can include: an array of lenslets or micro-lenses 76; a wafer 52 having read-out-integrated circuit (ROIC) cells 53, 54; a photodetector 75 interposed between the wafer 52 and lenslets array 76; and a plurality of conductor bumps 58 coupled to the photodetector 75 and wafer 52.

The photodetector 75 can include an etch stop layer 72; a p-type buffer layer 70 positioned on the etch stop layer 72; a plurality of photosensitive pixels 63 positioned on the p-type buffer layer, each pixel having a sequentially stacked layers of p-type superlattice 62, NID superlattice 64, and n-type contact 66; and n-type contact 68. The photodetector 75 can also include: a p-type contact 56 electrically connected to the p-type buffer layer 70; and a passivation layer 60 disposed over portions of the p-type buffer layer 70 and photosensitive pixels 63. The passivation layer 60 can include openings or holes through which the n-type contacts 68 can be coupled to the conductor bumps 58. The electrical signal generated by the photosensitive pixels 63 can be transmitted to the ROIC cells 53, 54 via the conductor bumps 58 and used to produce an integrated representation of the light incident on the lenslet array 76.

The photodetector 75 can be fabricated by any of several techniques. In an exemplary embodiment, a stack of planar layers can be formed on a substrate 74, wherein the stack of planar layers can include the etch stop layer 72, p-type buffer layer 70; p-type superlattice layer 62, NID superlattice layer 64, and n-type contact layer 66. The top three layers 62, 64, 66 can be etched to form a pattern of mesas or photosensitive pixels 63. The passivation layer 60 can be deposited over the mesas and portions of p-type buffer layer 70. The passivation layer 60 can be etched to form a pattern of holes or openings, and n-type contacts 68 can be formed in the openings. Alternatively, the n-type contacts 58 and passivation layer 60 can be sequentially positioned over the n-type contact layer 66 and the passivation layer 60 can be etched to form the holes, exposing the underlying n-type contact 68. The wafer 52 and conductor bumps 58, which can be prepared separately from the photodetector 75, can be aligned with the photodetector 75 and pressed against the photodetector 75 at a preset pressure and temperature so that the conductor bumps 58 can be reflowed and securely connected to the ROIC cells 53, 54 and n-type contacts 68.

In an exemplary embodiment, the substrate 74 can be removed by etching while the etch stop layer 72 can ensure that all of the substrate is etched and that over-etching will not damage the p-type buffer layer 70. Upon removal of the substrate 74, the lenslet array 76 can be attached to the etch stop layer 72 by a suitable adhesive that is transparent to the light directed by the lenslet array 76.

In another exemplary embodiment, the substrate 74 need not be removed from the photodetector 75. Instead, the substrate 74 can be interposed between the lenslet array 76 and the etch stop layer 72, i.e., the lenslet array 76 can be securely attached to the substrate 74 by, for example, a glue that is transparent to the light directed by the lenslet array 76. In an exemplary embodiment, the substrate 74 can be formed of material, such as GaSb, that is transparent to the light collected by the lenslet array 76.

In yet another exemplary embodiment, the substrate 74 need not be entirely removed from the photodetector 75. Instead, the substrate 74 can be etched to form the lenslet array 76. In an exemplary embodiment, the substrate is made of material that is substantially transparent to infra-red light, such as quartz, cast plastic, Si, GaAs, polymers, chalcogenide glasses, Ge, Si, GaSb, and ZnS.

In an exemplary embodiment, underfill material 69 filling the space between the wafer 52 and passivation layer 60 includes, but is not limited to, resin material, such as epoxy, and provides necessary mechanical strength to the device 50. It can also protect the pixels 63 from moisture, ionic contaminants, and hostile operational conditions, such as shock and vibration.

The photosensitive pixels 63 can include three layers 62, 64, and 66 that are respectively formed of the same materials as the layers 20, 22, and 24 in FIG. 1. Likewise, the n-type contacts 68, passivation layer 60, p-type buffer layer 70 can be respectively formed of the same materials as the n-type contact 26, passivation layer 32, and p-type buffer layer 18 in FIG. 1. It is noted that the p-type buffer layer 70 and the p-type superlattice layer 62 can be formed of materials that are transparent to the light. In an exemplary embodiment, the etch stop layer 72 is formed of a known material, such as AlGaAs, Al-InGaSb, or SiO₂, that is transparent to the light directed by the lenslet 76.

The photodetector 75 can include at least one mesa 71 that has the three layers 62, 64, and 66, passivation layer 60, and p-type contact 56 formed over the passivation layer 60. The mesa 71 can be fabricated in the similar manner as the other photosensitive pixels 63, with the differences that the passivation layer 60 can cover the side and top portion of the corresponding photosensitive pixel 63 and that the p-type contact 56 can be positioned over a portion of the passivation layer 60. The p-type contact can be electrically coupled to a ROIC cell 53 via one of the conductor bump 58.

The conductor bumps 58 can serve as electrical interconnection between the metal contacts 56, 68 and the ROIC cells 53, 54 formed on the wafer 52. The bumps 58 can be formed of metal to make metal-to-metal contact with the contacts 56, 68 and ROIC cells 53, 45. As material for the conductor bumps 58, Indium can be chosen due to the fact that it stays ductile even at liquid helium temperature, it is easy to work with and it forms a good bond at atmospheric temperature. The conductor bumps 58 may be fabricated by various ways. For instance, the wafer 52 can be positioned with the ROIC cells 53, 54 facing upward and the conductor bumps 58 can be formed on the ROIC cells by, for example, any known direct evaporation /lift-off technique.

It is noted that the active area of each photosensitive pixel 63 can be smaller than the projection area of each lenslet, reducing the dark current at high temperature, such as near room temperature. As in the case of FIG. 1, each lenslet of the array 76 can direct the incoming light onto the active area of a photosensitive pixel 63, allowing the active area to be reduced while most of the incoming light falls on the active area. Therefore, by use of the lenslet array 76, the dark current generated by the photosensors 63 can be reduced without compromising the sensitivity of the photodetector 75 and the quantum efficiency of the device 50.

In an exemplary embodiment, the ROIC cells 53, 54 can be formed on the wafer 52 that is based on Si, GaAs, InP, or the like. Each ROIC cell can serve as an electrical interface between the contacts 56, 68 and the external electrical signal processing circuit that may be included in the wafer 52. Photocurrent from each pixel 63 can be accumulated in an integration capacitor during a preset integration time. Then, the charge in the integration capacitor can be transferred to a circuit for reading the amount of charge.

In an exemplary embodiment, the superlattice layer 62 can include alternating layers of InAs and InₓGa₁₋ₓSb for 0<x<1 and each layer is doped with a n-type dopant, i.e., the layer 62 can be a n-type superlattice layer. In this embodiment, the layers 66 and 70 can be respectively p-type contact layer (formed or p-type semiconductor or p-type superlattice) and n-type buffer layer. Also, the contacts 56 and 68 can be respectively n-type and p-type contacts, while these contacts can be formed of metal, such as Pt, Pd, Au, Ge, Ni, Ti, Al, and tungsten.

While the invention has been described in detail with reference to specific embodiments thereof, it will be apparent to those skilled in the art that various changes and modifications can be made, and equivalents employed, without departing from the scope of the appended claims.

## Claims

1. A device for generating an electrical signal in response to light, comprising:
a photodetector including at least one superlattice layer operative to generate an electrical signal in response to light incident thereon; and
one or more lenslets for directing light onto the photodetector.

2. A device as recited in claim 1, wherein the photodetector incudes one or more photosensitive pixels, each of the pixels having a superlattice layer, a non-intentionally-doped (NID) superlattice layer, and a contact layer and wherein the active area of each of the pixels is smaller than the projection area of each of the lenslets.

3. A device as recited in claim 2, wherein the superlattice layer is a p-type superlattice layer and the contact layer includes at least one of an n-type semiconductor layer and an n-type superlattice layer.

4. A device as recited in claim 2, wherein the superlattice layer is a n-type superlattice layer and the contact layer includes at least one of a p-type semiconductor layer and a p-type superlattice layer

5. A device as recited in claim 2, wherein the photodetector includes:
a buffer layer positioned beneath the photosensitive pixels;
a first contact positioned on and electrically coupled to the buffer layer; and
one or more second contacts, each of the second contacts being positioned on the contact layer.

6. A device as recited in claim 5, wherein the buffer layer is a p-type buffer layer, the first contact is a p-type contact, and the second contacts are n-type contacts.

7. A device as recited in claim 6, wherein the buffer layer is formed of GaSb doped with a p-type dopant.

8. A device as recited in claim 5, wherein the buffer layer is a n-type buffer layer, the first contact is a n-type contact, and the second contacts are p-type contacts.

9. A device as recited in claim 8, wherein the buffer layer is formed of GaSb doped with a n-type dopant.

10. A device as recited in claim 1, wherein the lenslets are formed of material that is transparent to the light.

11. A device as recited in claim 1, wherein the lenslets are formed of material selected from the group consisting of quartz, cast plastic, Si, GaAs, polymers, chalcogenide glasses, Ge, Si, GaSb, and ZnS.

12. A device as recited in claim 5, wherein the first and second contacts are formed of metal.

13. A device as recited in claim 5, wherein each of the second contacts has an opening and is aligned with a corresponding one of the lenslets such that the light directed by the corresponding lenslet passes through the opening.

14. A device as recited in claim 5, comprising a substrate positioned beneath the buffer layer.

15. A device as recited in claim 14, wherein the substrate is formed of GaSb.

16. A device as recited in claim 5, comprising:
a passivation layer positioned over a portion of the buffer layer and portions of the photosensitive pixels.

17. A device as recited in claim 16, wherein the passivation layer is formed of material selected from the group consisting of silicon dioxide, silicon nitride, wide band-gap semiconductors, AlGaSb, and AlGaInSb.

18. A device as recited in claim 17, comprising:
adhesive material filled in a space between the passivation layer and the lenslets, the adhesive material being transparent to the light directed by the lenslets,

19. A device as recited in claim 5, comprising:
an etch stop layer positioned beneath the buffer layer and having a bottom surface facing the lenslets.

20. A device as recited in claim 19, wherein the etch stop layer is formed of material transparent to the light directed by the lenslets.

21. A device as recited in claim 19, comprising:
a substrate interposed between the etch stop layer and the lenslets and formed of material transparent to the light directed by the lenslets.

22. A device as recited in claim 21, wherein the substrate is formed of GaSb.

23. A device as recited in claim 19, comprising:
a substrate positioned beneath the etch stop layer and having a bottom portion etched to form the lenslets.

24. A device as recited in claim 19, wherein the lenslets are attached to the etch stop layer by adhesive material that is transparent to the light directed by the lenslets.

25. A device as recited in claim 19, comprising
a passivation layer positioned on a portion of the buffer layer and portions of the pixels;
a plurality of conductor bumps respectively attached to the first and second contacts;
a wafer; and
a plurality of readout-integrated-circuit (ROIC) cells formed in the wafer and respectively attached to the plurality of conductor bumps.

26. A device as recited in claim 25, comprising:
adhesive material filling a space between the passivation layer and the wafer.

27. A device as recited in claim 25, wherein the conductor bumps are formed of indium.

28. A device as recited in claim 2, wherein the NID superlattice layer includes alternating layers of InAs and InₓGa₁₋ₓSb for 0<x<1.

29. A device as recited in claim 28, wherein the superlattice layer includes alternating layers of InAs and InₓGa₁₋ₓSb for 0<x<1 and wherein each of the alternating layers is doped with material selected from the group consisting of p-type dopant and n-type dopant.

30. A device as recited in claim 1, wherein the light is infrared light.

31. A method of forming an image of an object, the method comprising:
exposing a lenslet to light emitted from an object to cause the lenslet to direct the light onto a superlattice layer of a photodetector thereby causing the photodetector to generate an electrical signal in response to the light; and
generating an image of the object from the electrical signal.
